# EUROPEAN PATENT SPECIFICATION

(11) **EP 2 201 600 B1**
(45) Date of publication and mention of the grant of the patent: **02.01.2019**
(21) Application number: 08838610.7
(22) Date of filing: 15.10.2008
(51) Int. Cl.: H01L 23/48, H01L 21/768

(54) **METHOD FOR PRODUCING THROUGH-SUBSTRATE VIAS**
VERFAHREN ZUR HERSTELLUNG VON SUBSTRATDURCHKONTAKTIERUNGEN
PROCÉDÉ DE FABRICATION D'INTERCONNEXIONS VERTICALES TRAVERSANTES

(30) Priority: 15.10.2007 US 980136 P
(43) Date of publication of application: 30.06.2010
(73) Proprietor: IMEC VZW, 3001 Leuven (BE)
(72) Inventor: SWINNEN, Bart, B-3220 Holsbeek (BE); SOUSSAN, Philippe, F-13009 Marseille (FR); SABUNCUOGLU TEZCAN, Deniz, B-3400 Neerwinden (BE); DE MOOR, Piet, B-3210 Linden (BE)
(74) Representative: Patent Department IMEC
(86) International application number: PCT/EP2008/063892
(87) International publication number: WO 2009/050207

(56) References cited:
- EP-A- 0 974 817
- JP-A- 2005 223 265
- JP-A- 2005 285 972
- US-A1- 2005 221 601
- US-A1- 2006 278 989
- US-A1- 2007 048 896

## Description

### Technical field of the Invention

The present invention relates to the field of electrical interconnection technologies for microelectronics system elements. In particular, the present invention relates to methods for producing electrical through hole interconnects.

### Background of the invention

The evolution of very-large-scale integration (VLSI) technology calls for an increasing bandwidth of interconnects between integrated circuits (IC's) and/or other system elements. For short interconnects, electrical signal lines maintain the highest capacity and speed. In order to keep up with the increasing speed and density requirements, system in a package (SIP) technology is increasingly used. This creates the need for 3-dimensional interconnects.

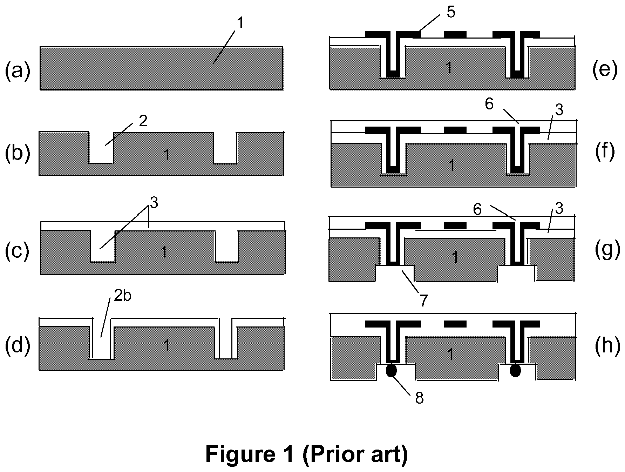

An example of the fabrication of interconnects can be found in patent US-6908856, in which a method for the fabrication of a device comprising electrical through hole interconnects is disclosed. This prior art method is illustrated in Fig. 1(a) to Fig. 1(h) and comprises providing a substrate 1 (Fig. 1(a)); dry etching in said substrate 1 so as to form at least one substrate hole 2 (Fig. 1(b)); depositing a first layer of patternable dielectric material 3 on said substrate 1, whereby said substrate holes 2 are filled with said dielectric material 3 after which the substrate surface is planarised (Fig. 1(c)); anisotropically dry etching of the patternable dielectric material 3 within the substrate holes 2 so as to form at least one dielectric hole 2b within the substrate hole 2 until the bottom of the substrate hole 2 is reached, whereby the sidewalls of the substrate hole 2 remain covered with the first layer of patternable dielectric material 3, thus forming a dielectric hole 2b (Fig. 1(d)); depositing a layer of conductive material 5 on the bottom and on the sidewalls of the dielectric hole 2b so as to transform the dielectric hole 2b into a conductor hole (Fig. 1(e)); and depositing a second layer of patternable dielectric material 6 on top of the layer of conductive material 5, whereby the conductor hole is filled (Fig. 1(f)). The fabrication of the interconnects may be completed by etching the substrate 1 from the back side, hereby creating holes 7 and halting when the conductive material 5 and the dielectric material 3 are reached (Fig. 1(g)), and the addition of solder bumps 8 on the studs of conductive material 5, for bonding purposes (Fig. 1(h)).

It is a disadvantage of the above fabrication method that the dielectric coverage of the via sidewalls and corners is not uniform, so there is a non-conformal deposition. A disadvantage of this approach is limited scalability of this via. Also dielectric patterning with high aspect ratio becomes difficult. Typically a sidewall angle is observed in the dielectric pattern which limits the smallest dimension that can be opened at the bottom of the via. Furthermore, the dielectric material 3 does not necessarily planarize the surface, it should be just conformal.

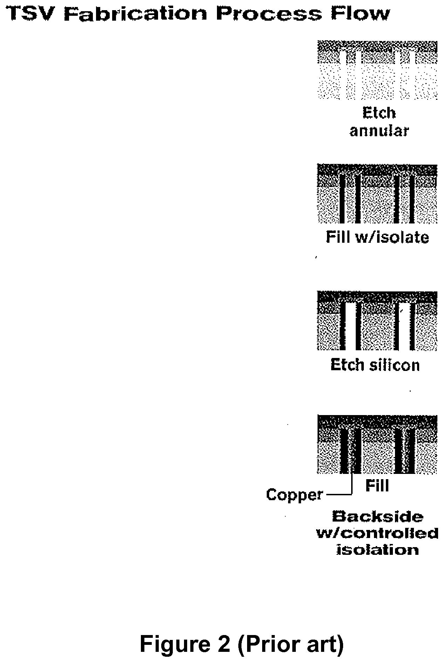

In the article "Enabling 3D design", Arthur Keigler et al., Semiconductor International, August 2007, p40, a method for creating an interconnect is disclosed, as illustrated in Fig.2, whereby, for creating two interconnects, two rings are etched in a silicon substrate, which are then filled with an isolation material, resulting in inner pillars of silicon, laterally surrounded by the isolation material. The inner pillars of silicon are then etched away and the resulting hole is filled with copper.

It is a disadvantage of the above fabrication method that the isolation filling is done with oxidation, being a high temperature process. In case the oxide is deposited with CVD there will be a gap/seam at the centre of the filling ring.

US 2007/0048896 discloses various methods of forming TSVs by forming a ring isolation around a pillar of substrate material, removing the pillar by etching from the backside or the front side and metallizing the hole so formed.

US 2005/0221601 discloses another method of forming a TSV by providing a ring isolation and removing the resulting semiconductor pillar by etching from the backside.

JP2005285972 discloses yet another TSV method including forming a ring isolation using a polymer material deposited by spin-on. The central semiconductor pillar is not removed.

### Summary of the invention

It is an object of embodiments of the present invention to provide a good method for the fabrication of interconnects. The above objectives are accomplished by a method according to claim 1. The present invention provides a method for the fabrication of at least one electrical interconnect in a substrate. The method comprises:
- Providing a substrate being a semiconductor wafer or die made of a substrate material and having a first main surface and comprising a back-end-of-line (BEOL) and a front-end-of-line (FEOL), wherein the first main surface is the backside of the wafer or die, i.e. the side which is remote from the BEOL;
- Producing at least one ring structure in a substrate from the first main surface, the at least one ring structure surrounding an inner pillar structure of substrate material with a top, and having a bottom surface;
- Filling the at least one ring structure with a first dielectric material with spin-on or spray-on or CVD in the ring structure and on the first main surface;
- Removing the first dielectric material to a level equal or higher than the first main surface;
- Applying a second dielectric material on the first main surface;
- Removing the second and first dielectric material when present from the top of the inner pillar structure to open up the pillar structure;
- Removing the inner pillar structure down to the bottom surface of the ring structure, leaving a pillar vacancy selectively to the dielectric material surrounding the pillar structure wherein the removal of the pillar structure stops on an interlayer dielectric (ILD) layer of the substrate that is subsequently selectively removed in a second removal step to an underlying metal layer and stops on the underlying metal layer;
- Providing a conductive inner pillar structure in the at least one ring structure, by at least partially filling the pillar vacancy with a conductive material, thereby forming at least one interconnect structure, the at least one interconnect structure forming an electrical path from the bottom surface up until the first main surface.

According to embodiments of the present invention, the dielectric material is also applied on the first main surface in liquid phase.

In accordance with embodiments of the present invention, producing ring structures may be performed by etching, e.g. by dry or wet etching.

The inner pillar structure may be removed by dry and/or wet etching.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the claims. The reference figures quoted below refer to the attached drawings.

### Brief Description of the Drawings

Fig. 1 and Fig. 2 illustrate prior art methods for the fabrication of electrical interconnects.
Fig. 3 illustrates interconnect structures according to embodiments of the present invention (a) with dielectric layer on the surface and (b) without dielectric layer on the surface.
Fig. 4(a), (b), (c), and (d) illustrate method steps of a fabrication method according to an embodiment of the present invention.
Fig. 5 illustrates method steps of a fabrication method according to an embodiment of the present invention.
Fig. 6 illustrates a generic part of 3 different method embodiments of the present invention, the remainder (non-generic part) of these methods being illustrated respectively in Fig. 7, Fig. 8 and Fig. 9, which each start where Fig. 6 ends.
Fig. 7 illustrates an embodiment in which the pillar vacancy is completely filled with a conductive material. Interconnect lines can be processed at the same time while filling with the conductive material.
Fig. 8 illustrates an embodiment in which the pillar vacancy is provided with a conformal metal film, leaving an inner conductor ring. This ring is then later filled up with a second dielectric material. The second dielectric material can be the same as the dielectric material used to fill the ring structure. Afterwards interconnect lines can be provided on top of the second dielectric material.
Fig. 9 illustrates an embodiment in which the pillar vacancy is provided with a conformal metal film, leaving an inner conductor ring, which is further not filled with a dielectric.
Fig. 10 shows partially filled trenches in areas with a high trench density.
Fig. 11 shows the dimple at the top of the vias (a) in case of filling the trench with BCB and (b) in case of filling the trench with RH8023.
Fig. 12 shows the dimple in the first dielectric layer formed on the locations of the ring structures.
Fig. 13 shows the planarization of the dielectric layer by using a combination of two dielectric layers.
Fig. 14 shows the opening of the dielectric layer on top of the inner pillar without further planarization of the first dielectric layer.
Fig. 15 shows a topography measurement after patterning the second dielectric layer on top of the center pillar. Both first (for filling) and second (for surface coverage) dielectric layers are the same material with the same viscosity version of the same material.
Fig. 16 shows a topography measurement after patterning the dielectric layer on top of the center pillar. The second dielectric on top has a higher viscosity than the first dielectric in the trenches.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

All numbers expressing dimensions, temperatures and so forth used in the specification and claims are to be understood as being modified in all instances by the term "about". Accordingly, unless indicated to the contrary, the numerical parameters set forth in the specification and attached claims are approximations that may vary depending upon the desired properties sought to be obtained by the present invention.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment.

Furthermore, while some embodiments described herein include some but not other features included in other embodiments, combinations of features of different embodiments are meant to be within the scope of the invention, and form different embodiments, as would be understood by those in the art.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention as defined by the appended claims. The embodiments and examples described below do not limit the scope of the claims and they can be slightly changed by ordinary steps known in the art in order to optimize applicability in specific practical situations. Some particular practical embodiments are described below.

Embodiments of the present invention relate to methods for producing electrical through-hole interconnects for making 3D stacks of semiconductor wafers and chips, e.g. Si wafers and chips, and for packaging applications of MEMS devices. Embodiments of the present invention relate to electrical through-hole interconnects for making 3D stacks of semiconductor wafers and chips, e.g. Si wafers and chips, and for packaging applications of MEMS devices.

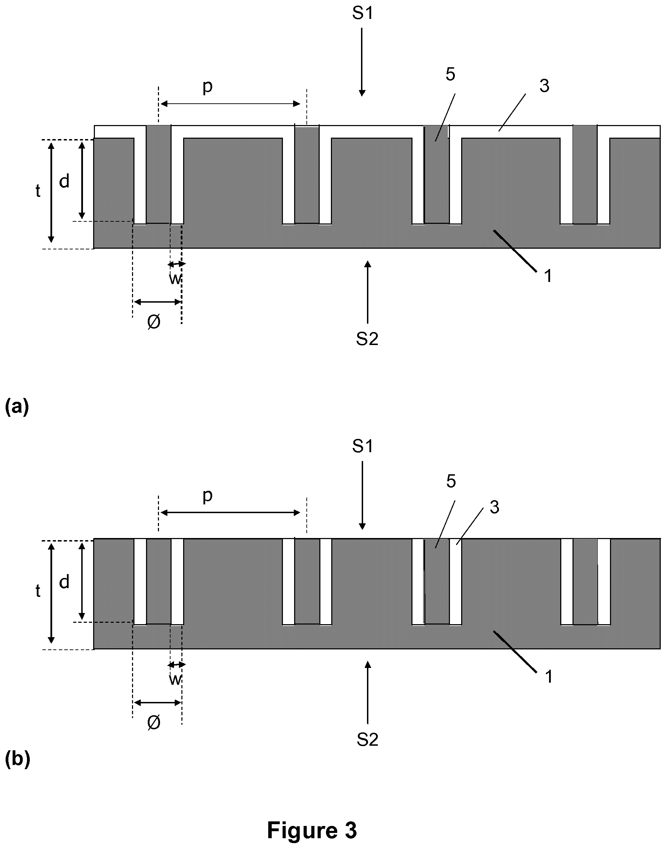

Figs. 3 (a) and (b) illustrate an exemplary electrical interconnect structure. Such electrical interconnect structure may be obtained by methods as explained below. The interconnect structure comprises a conductive inner pillar structure 5 surrounded by a ring structure of first dielectric material 3. The first dielectric material may (Fig 3(a)) or may not (Fig. 3(b)) be present on the surface. The thickness non-uniformity of the first dielectric layer 3 surrounding the pillar structure 5 is between 0.5% and 10%. It is advantageous that the dielectric material 3 of an interconnect structure according to embodiments of the present invention has a very uniform thickness on the top surface. This is advantageous for further processing especially when lithography is used to open the inner pillars. This will allow uniform resist coating and good CD control.

Figs. 3(a) and (b) show typical dimensions of a device according to embodiments of the present invention. The wafer or substrate thickness t can be e.g., about 20 µm, or about 30 µm, or about 50 µm, or about 75 µm or about 100 µm, or can vary for example between 10 µm and 500 µm or between 20 µm and 300 µm, or between 20 µm and 100 µm or between 30 µm and 75 µm. The outer diameter φ of the ring structure can be e.g., about 100 µm, about 50 µm, about 25 µm, about 20 µm, about 15 µm, about 10 µm; for example between 50 µm and 10 µm. The inter-ring distance or pitch p (for example measured from the center of one ring structure to the center of another ring structure) is preferably larger than the outer diameter φ of the ring structure and can be e.g., 40 µm, 17 µm, 15 µm, 13 µm, 10 µm, 7 µm, 3 µm, 2 µm, 1 µm, for example between 100 µm and 1 µm or between 50 µm and 1 µm, or between 40 µm and 1 µm. The ring structure width w is preferably smaller than the outer diameter φ of the ring structure and may be below 10 µm, or below 7 µm, or below 6 µm or below 5 µm, or can vary between 20 µm and 50 nm 0.5 µm, between 10 µm and 0.5 µm, between 15 µm and 2 µm or between 10 µm and 3 µm or between 7 µm and 5 µm or between 5 µm and 1 µm. For example, in a particular embodiment, the depth d of the ring structure can be 50 µm, the diameter φ can be 25 µm, and the distance or pitch p can be 40 µm. Typical trenches forming the ring structure can have an aspect ratio of about 10 or 10:1, the aspect ratio being defined as depth/width|ₕₒₗₑ. Aspect ratios of 20 or higher are not excluded. Also smaller aspect ratios are not excluded. The aspect ration can vary between 1 and 100, but also aspect ratios between 1 and 500, or between 1 and 1000 are possible.

Another aspect of the invention is a method for producing interconnect structures, more particularly electrical interconnects, between microelectronic elements. The method has the advantage that it is relatively easy to perform. It can be applied relatively cheaply compared to the state of the art methods for forming electrical interconnects. Embodiments of the method of the present invention can, for instance, be applied in thin chip technology as MCM (Multi Chip Module) and system in a package (SIP) technology. Embodiments of the method of the present invention may be applicable to Wafer Level Packaging (WLP) technology as well as Stacking of IC (SIC) Technology, and/or MEMS packaging. These technologies are referred to as 3D-WLP and 3D-SIC technologies in the art when referring to the aspect of creating 3-dimensional interconnects. Therefore electrical through hole interconnects are realized for making 3D stacks of semiconductor, e.g. Si, wafers and chips, for packaging applications of MEMS devices, ...

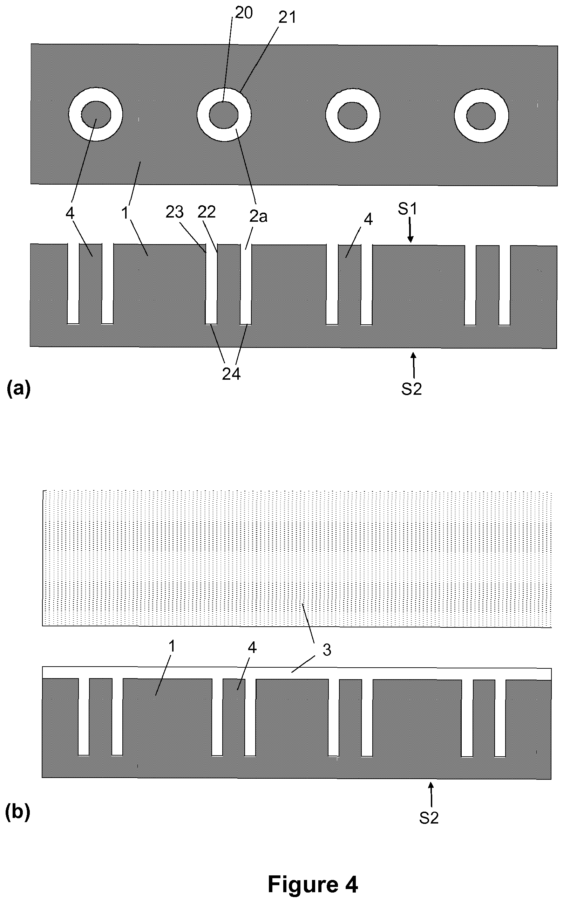

A general overview of method steps of an exemplary method for the fabrication of electrical interconnects in a substrate 1 are illustrated in Fig. 4(a) to Fig. 4(d). The top parts of these drawings are top views, while the bottom parts of these drawings are cross-sections through the substrate 1 in a direction perpendicular to a main surface S1 of the substrate 1.

The process flow comprises:
- providing a substrate 1 of substrate material, the substrate 1 having a first main surface S1;
- producing a ring-structure 2a e.g. a ring-trench in the substrate 1 at the side of the first main surface S1. This can be done by using a photoresist layer on the first main surface S1 in which a ring-like trench can be defined, e.g. by using state of the art lithography techniques on the first main surface S1. Then the ring-structure 2a is fabricated in the substrate 1 by removing substrate material, e.g. by etching a circular trench in the substrate 1 (e.g. Si substrate etch), thus producing an inner pillar structure 4 of substrate material;
- filling the ring-structure 2a with a dielectric material 3, preferably a fluid, hereby also providing a layer of dielectric material 3 on the first main surface S1;
- providing a conducting inner pillar structure. In embodiments of the present invention, the inner pillar structure may already comprise a conducting material, for example conductive silicon. In case the material of the inner pillar structure does not provide a conducting path from the top to the bottom of the structure, the following steps can be performed. The dielectric material 3 can be patterned so as to free at least the location of the substrate pillar structure 4, removing, e.g. etching away, the substrate pillar structure 4, e.g. silicon substrate or silicon substrate further comprising ILD layer, thus leaving a pillar vacancy 2b; and filling the pillar vacancy 2b with conductive material, e.g. metallizing the vacancy 2b.

The ring-structure surrounding the inner pillar structure can be circular or more oval in cross-section substantially parallel with the first surface of the substrate, or can even have a shape with corners or rounded corners (for example can be a square, a hexagon, or more generally a polygon; the polygon shapes can be regular or irregular...).

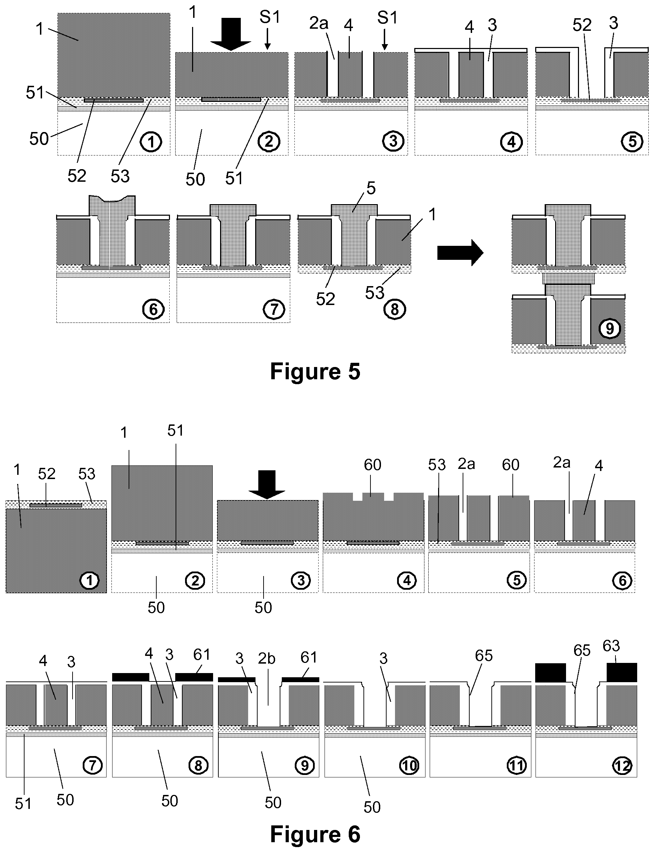

Each of the above method steps, as well as a few other optional method steps, are described below in more detail. Different detailed method flows according to embodiments of the present invention are illustrated in Figures 5 to 9.

### (A) Providing substrate 1

In a first step of the method, a substrate 1 of substrate material is provided, the substrate 1 having a first main surface S1. The substrate 1 can be a wafer or a processed wafer. It can be a microelectronics component, possibly bonded to a wafer. In particular embodiments, the substrate 1 is a semiconductor substrate. The substrate 1 may comprise silicon or conductive silicon (for example realised by implantation), and in particular embodiments may be a silicon substrate or a conductive silicon substrate. The substrate 1 may comprise electronic or MEMS devices. According to the present invention, the substrate 1 is a semiconductor wafer or die comprising a back-end-of-line (BEOL) and a front-end-of-line (FEOL), wherein the first main surface S1 is the backside of the wafer or die, i.e. the side which is most remote from the BEOL. The substrate thickness may be between 10 µm and 500 µm, for example between 20 µm and 300 µm, e.g. between 20 µm and 100 µm. In particular embodiments, the substrate thickness may be about 50 µm.

### (B) Producing ring structure 2a - Fig. 4a

In a next step, a ring structure 2a is produced in the substrate 1 from the first main surface S1 towards a second main surface S2 opposite the first main surface S1, the ring structure 2a surrounding an inner pillar structure 4 of substrate material as illustrated in Fig. 4a. The ring structure 2a does not extend down to the second surface S2, so that the ring structure 2a has a bottom surface 24. The ring structure 2a may be produced by etching the substrate 1, e.g. through a mask or by lithography. The etching of the substrate 1 may for example be performed by dry etching and/or wet etching. In particular embodiments Deep Reactive Ion Etching - Inductive Coupled Plasma (DRIE-ICP) may be used. In certain embodiments of the present invention, where the substrate 1 is a semiconductor wafer or die comprising a BEOL and a FEOL, the ring structure 2a may be etched up until a metal layer of the BEOL or on top of the BEOL. The ring structure 2a can also be etched down to the contacts forming the connection between the FEOL and BEOL.

In particular embodiments the ring structure 2a has a constant width w. In particular embodiments the ring structure 2a is defined in the plane of the first main surface S1 by 2 concentrical circles 20, 21 (inner and outer border of the ring structure 2a - see top part of Fig. 4a), and is further defined in the direction orthogonal to the first main surface S1 by an inner and an outer sidewall 22, 23 corresponding to the concentrical circles 20, 21, respectively. The inner sidewall 22 and outer sidewall 23 are connected by a bottom surface 24. The width w of the ring structure 2a is defined by the average distance between the 2 concentrical circles 20, 21.

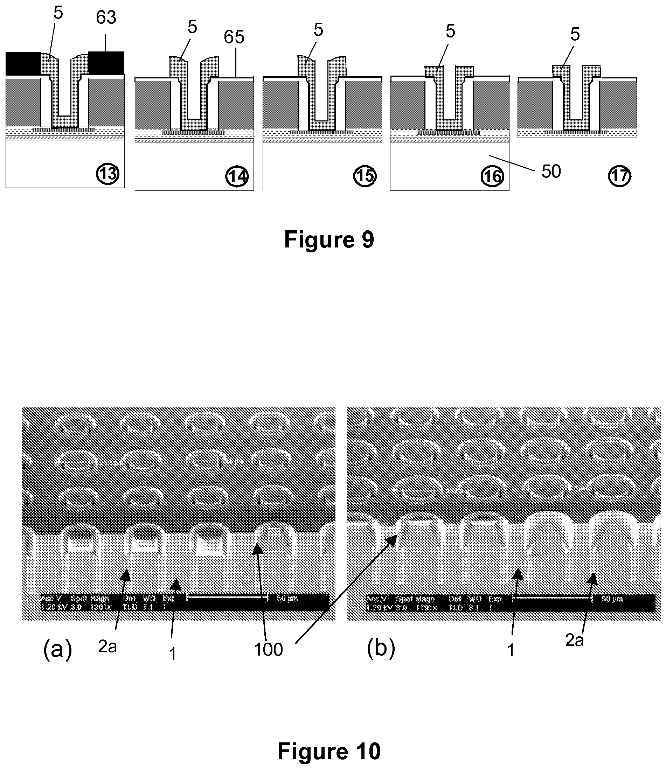

In particular embodiments the average width w of the ring structure 2a is larger than 0.5 µm. In particular embodiments of the present invention, the average width of the ring structure 2a is smaller than 20 µm, or smaller than 10 µm, or smaller than 7 µm, or smaller than 6 µm or below 5 µm or below 4µm, or can vary between 20 µm and 0.5 µm, between 10 µm and 0.5 µm, between 15 µm and 2 µm or between 10 µm and 3 µm or between 7 µm and 5 µm. In case of large widths w, more material is needed to fill the trenches. Also in areas with high density of trenches, the trenches are only partially filled if limited amount of dielectric material is used. This is illustrated in Fig. 10, showing a vertical cross-section of a substrate 1 provided with a ring structure 2a filled with dielectric material 3 (in accordance with step (D)). The ring structure 2a illustrated has a constant width w of 5 µm.

The creation of voids 100 can be avoided by optional dielectric coating steps, wetting layers, and other treatments.

### (C) Providing etch stop layer, diffusion barrier layer

Optionally, in particular embodiments of the present invention, before filling the ring structure 2a with dielectric material 3, an extra layer (not illustrated) can be applied on the sidewalls 22, 23 and bottom surface 24 of the ring structure 2a. This extra layer can improve later selective removal of the inner pillar structure 4 with respect to the dielectric material 3 the ring structure 2a will be filled with, if the material of the inner pillar structure 4 can better be selectively removed with respect to the extra layer than with respect to the dielectric material 3. The extra layer then functions as an etch-stop layer.

The extra layer may also be a diffusion barrier layer, which prevents later on diffusion of conductive material 5 (e.g., Cu, Al, ...) into the dielectric material 3 and into the neighbouring substrate 1, i.e. into the neighbouring non-pillar substrate (for example in case the dielectric material 3 e.g. polymer inside the ring structure 2a is not sufficiently for preventing such diffusion).

The extra layer may also be such that it provides appropriate wetting properties so as to enhance the fill efficiency for the dielectric material 3 into the ring structure 2a when filling, e.g. for avoiding formation of voids 100 as illustrated in Fig. 10.

In embodiments of the present invention the extra layer combines two or all of these functionalities.

The extra layer may comprise different sub-layers each providing one or more of these functionalities. In combinations where a wetting sub-layer, i.e. a sub-layer providing appropriate wetting properties, is provided, this sub-layer is preferably provided last, so that it thus eventually is in contact with the dielectric material 3. Before that, a barrier layer, i.e. a sub-layer providing appropriate diffusion barrier properties, can be provided. In case a sub-layer is applied to improve selective removal of the pillar structure 4 with respect to the dielectric 3, this layer is preferably applied first.

In embodiments where an extra layer is applied, possibly comprising sub-layers, these layers may also have to be removed at the top of the inner pillar structure 4 (step E) before the inner pillar structure 4 itself can be removed (step F).

A silicon oxide can have the function of barrier layer, an etch stop layer and a wetting layer at the same time. Other barrier layers include Ta(x), Ti(x). Ti(x) can also serve as a wetting layer. The notation "Element(x)" is used when any Element-alloy or Element-compound is meant. The barrier layer may comprise silicon oxide, Ta or Ti. The wetting layer may comprise Ti or silicon oxide. The etch stop layer may comprise silicon oxide.

In yet alternative embodiments, no extra layers are provided between producing of the ring structure 2a as in step (B) and filling of the ring structure as in step (D), but only pre-wetting can be performed to improve the filling in step (D). Pre-wetting is introducing a solution, (may be spun and cured), before spinning the dielectric material. This can make the surface hydrophilic and helps the dielectric material, e.g. polymer to flow into the trench. The pre-wetting agent can be the solvent of the dielectric.

### (D) Filling the ring structure 2a with a dielectric material 3 - Fig. 4b

Filling of the ring structure 2a with dielectric material 3 is illustrated in Fig. 4b. In advantageous embodiments of the present invention, the average width of the ring structure 2a is chosen such that the ring structure is completely filled with the dielectric material 3, thus leaving no voids underneath the dielectric material 3 (see above).

A vacuum step may be added to ensure proper filling of the ring structure 2a, e.g. Si substrate holes. If the dielectric material 3 is benzocyclobutene (BCB) this is advantageously performed at about 170°C as this material exhibits its largest flow at that temperature, before it starts to cure at higher temperatures. RH8023 does not need to be applied at high temperatures such as e.g. 170°C. It is flowing at room temperature.

According to the present invention, the dielectric material 3 can be spin-on or spray-on or CVD-deposited polymer. According to other embodiments, the dielectric material 3 can be deposited/grown oxides or nitrides. According to embodiments of the present invention the dielectric 3 is applied in the ring structure 2a in liquid phase. The dielectric material 3 can be applied by spin coating or spray coating a layer of dielectric material on top of the first main surface S1.

The applied dielectric material 3 is typically not only filling the ring structure 2a, but is also forming a layer on top of the main first surface S1.

In particular embodiments, the dielectric material comprises, or consists of, Benzo Cyclo Butene (BCB). In other embodiments it comprises or consists of silicone, Epoxy-based materials, or spin on dielectrics from R&H as for instance R&H 8022 and 8023 (with various viscosity versions).

In particular embodiments of the present invention, the dielectric material 3, e.g. BCB, is applied when the substrate 1 is heated above 20°C or above 30°C or above 40°C or above 50°C, or above 60°C, or above 70°C, or above 80°C, or above 90°C, or above 100°C, or above 110°C, or above 120°C.

Also RH8023 can be used. In this case the filling can be done at lower temperatures, even at room temperature. The substrate heating leads to lower viscosity of the dielectric material 3, which may be advantageous for filling properties of the dielectric material 3, as illustrated in Fig. 10, where the top of the trenches is not filled in areas with high trench density.

One, two or more, a multiple of subsequent spin coating steps and/or spraying steps can be applied to improve the efficiency of filling the ring structure 2a with the dielectric material 3. Also planarization of the dielectric material 3 can be improved using subsequent spin coating steps. When using certain materials, e.g. BCB, in dense structures these materials fill the trench only half way (or 2/3) from the bottom due to limited amount of material available on the wafer. In such case, a second (sometimes even third, fourth, ...) dielectric coating can help to complete the fill. Furthermore the surface topography may improve (i.e. the surface roughness is reduced) by multiple coatings. The planarising dielectric material(s), that can be one or more extra layers on top of the first dielectric coating, can preferably be benzocyclobutene (BCB) or RH8023-10. Also RH8023-2 can be used. The dielectric material can be diluted with its suggested/relevant solvent. These multiple spin coating steps typically result in a flatter front surface.

In preferred embodiments the dielectric material 3 is chosen and applied such that the resulting structure provided with the dielectric material 3 has an essentially flat topology (flat front surface of the wafer). The dielectric material 3 forming a layer on top of the first main surface S1 may also be non-uniform, for example the surface thickness of the applied dielectric material 3 is not uniform. It may be thicker on less dense via regions while thinner on regions with a higher via density. This may be caused by the fact that more dielectric material is consumed for filling the ring trenches 2a.

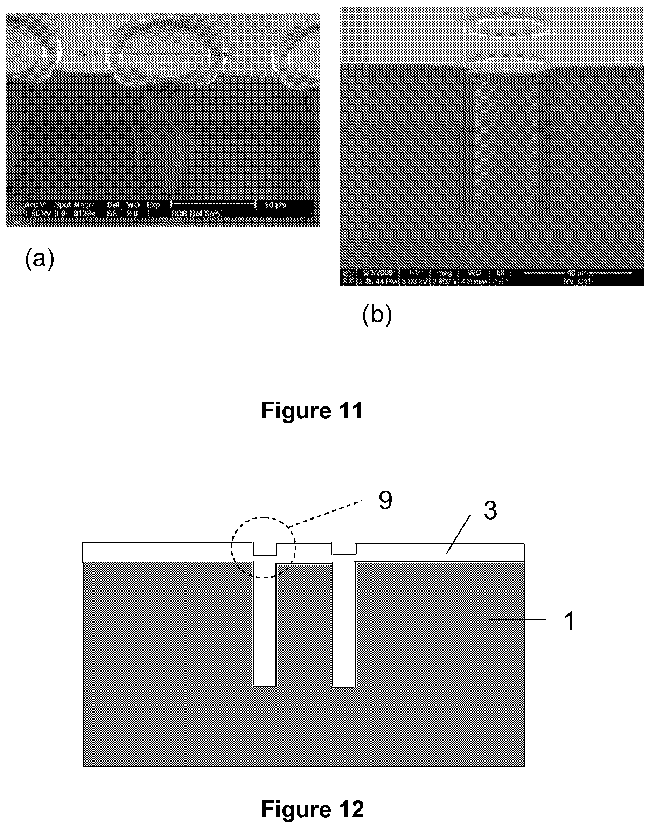

Furthermore, a dimple 9 may be formed just on top of the ring trenches 2a/vias (see Fig. 11 and Fig. 12).

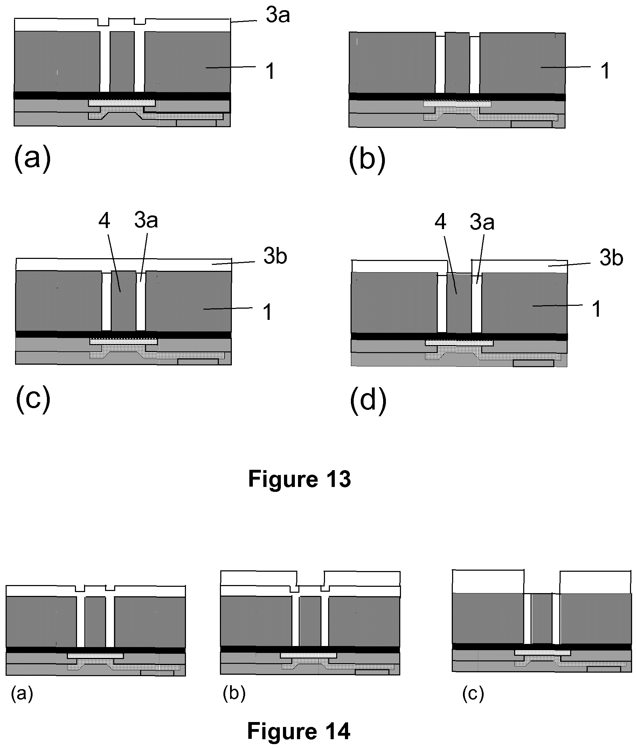

This non-uniformity/topography of the dielectric material 3 on the surface S1 may cause problems in subsequent process steps, for example when the dielectric material 3 is patterned on top of the inner pillar structure 4 for removal thereof. Fig. 14 shows a problem that can arise in case of a dimple at the locations of the trenches. In Fig. 14, opening of the dielectric layer on top of the inner pillar without further planarization of the first dielectric layer is represented. Fig. 14(a) represents the topography of the first dielectric layer including a dimple at the locations of the trenches. Due to topography of the single layer polymer fill, resist spun on it, is not uniform. Fig. 14(b) represents the topography of the resist layer after opening the resist layer on top of the inner pillars. Further dry etch selectivity to resist is typically low (both are kind of polymers) so CD enlarges (see Fig. 14(c)). The problem becomes larger with the increased thickness of polymer since CD loss is directly related to etch time, which in turn is directly related to material thickness to be removed. This is why according to embodiments of the present invention the double coating idea is applied: both to remove topography and to be able to use photo patternability of the dielectric material.

During lithography either an extra resist layer can be deposited on the dielectric 3 or the dielectric material 3 can be chosen to have itself lithographic properties. The extra topography results in different height of the mask (being either the dielectric 3 itself or an extra resist layer on top thereof) during lithography and this may cause problems because of the limited depth-of-focus during illumination. Furthermore the dielectric material 3 having litho properties or the extra resist layer on top may have a non-uniform thickness. During development, thinner regions develop faster than thicker regions eventually resulting into non-uniform print and CD loss. If the dielectric material 3 is not photopatternable, it can be patterned with a hard and/or resist mask accompanied by dry etch. Still thinner regions will be etched away faster than thicker regions, resulting in CD loss. Further, in case the selectivity of dry etch process to resist compared to the dielectric material is low, a thick (thicker than the dielectric material) resist layer is required for the patterning. This may also introduce problems during contact alignment structure, making alignment very difficult due to image blur through thick layers.

The above-mentioned problems are solved by applying a dielectric layer twice. This can be the same dielectric layers or the same materials with different viscosities, or different material with the same or a different viscosity Preferably the second dielectric layer has a higher viscosity than the first dielectric material, but in alternative embodiments the first dielectric layer can also have a higher viscosity than the second dielectric material. This allows to separate trench filling requirements from patterning requirements. The procedure can be divided into essentially 3 steps (Fig. 13(a), (b), (c)).

First dielectric layer 3a is chosen for trench filling capabilities and used to fill the trenches 2a (see Fig. 13(a)). It can be photopatternable or not.

In a second step the first dielectric layer 3a is then etched back. In the best case the top surface is very smooth. During etch back the first dielectric layer 3a can be only partially removed, or etch-back can be done until the surface of the wafer 1 is completely exposed/cleaned, as represented in Fig. 13(b)). At this stage slight over-etch can be done to clean the wafer surface completely. In the best case the wafer surface is clean of dielectric layer 3a. The trenches/vias are still substantially completely filled with the dielectric layer 3a. In the best case the trenches 2a are completely filled with dielectric material 3a, such that the remaining topography is limited.

In a third step, a second layer of dielectric material 3b is applied on the surface. Since the trenches are filled before applying the second dielectric layer 3b (see Fig. 13(c)), the topography on the wafer surface is lower compared to the non-filled case. The second layer of dielectric material 3b will distribute uniformly, more uniformly compared to first layer 3a.

The second dielectric layer 3b may be of the same dielectric material as the first dielectric material 3a or may be the same material with a different viscosity or may be a different dielectric material. In particular embodiments, the second dielectric layer is thin, i.e. 10 µm, even better below 5 µm, even better below 2 µm for example around 2 µm. This facilitates contact alignment and the field visibility is better for visible light source. This only holds for particular alignment schemes, and is not relevant in case of for example front to back side alignment or infrared alignment. The material can be chosen to tune the surface thickness of the dielectric layer 3b or the material can be chosen for a specific material property, e.g. resistance to dry or wet etch. In both cases, the choice will depend on the application where this isolated via is used.

The second dielectric material 3b is preferably benzocyclobutene (BCB) or RH8023-10. Preferably the second dielectric material 3b is a photo BCB or a non-photo benzocyclobutene (BCB). Also RH8023-2 can be used.

In particular embodiments the dielectric material 3 and the width w of the ring structure 2a are predetermined such that the ring structure 2a is completely filled by the dielectric material 3, at a predetermined temperature as for instance room temperature, or any temperature below 250 °C, or below 150 °C. For certain applications the temperature during processing needs to be limited and still the trenches need to be filled with dielectric material. A proper choice of the filling material and/or the dimensions of the trenches may facilitate filling under these circumstances.

In particular embodiments the dielectric material 3, the width w of the ring structure 2a, and the average inter-ring structure distance p or ring structure density are predetermined such that the ring structure 2a is completely filled by the dielectric material 3.

In particular embodiments the dielectric material 3 for the interconnect structure, the width w of the ring structure 2a, and the average inter-ring structure distance p or ring structure density are predetermined such that the ring structure 2a is completely filled by the dielectric material at a predetermined temperature, as for instance room temperature, or at any temperature below about 250 °C, or below about 150 °C, such that, for example, ICs are not destroyed by the temperature budget. This via may be used in post CMOS processing and specifically for example for memory applications. In that case the temperature is preferably as low as possible, even below 130°C. In certain embodiments the dielectric material can be applied on a heated substrate. The dielectric material can be locally heated, such that the viscosity is locally changed/reduced. That way flowing is enhanced and better filling can be achieved. The substrate 1 can for instance be heated to one of about 20, 30, 40, 50, 60, 70, 80, 90, 100, 110, 120, 130, 140, 150, 160, 170 °C.

### (E) Patterning of dielectric material 3

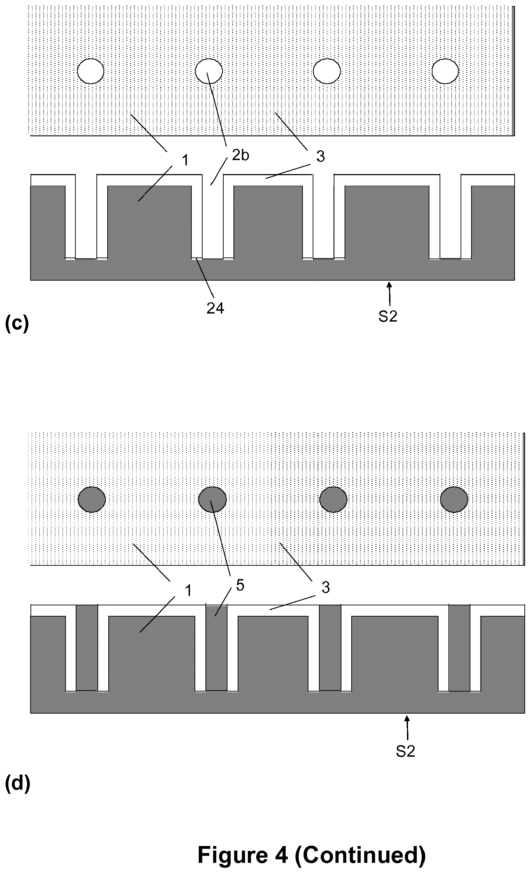

The dielectric material 3 on the first main surface S1 is patterned so as to open the layer of dielectric material 3 at least on top of the inner pillar structure 4 (not illustrated in Fig. 4). According to certain embodiments of the present invention, opening the layer of dielectric material 3 in at least the region above the inner pillar structure may be performed by lithography and etching.

In case a first and a second dielectric material 3a, 3b have been applied as illustrated in Fig. 13, the second dielectric material 3b can be removed from the top of the inner pillar structure 4 (see Fig. 13(d)) to open up the pillar structure 4 during step (E). This can be done by extra lithography and etch steps. In a particular embodiment, the second dielectric layer 3b can be chosen to be photopatternable. As such the second dielectric material 3b can be removed from the top of the inner pillar structure 4 by standard litho process without extra resist coating on top. As such the uniformity of the print can be improved and CD loss problems can be reduced.

In case the inner pillar structure is a conductive material, for example conductive silicon, for example realised by implantation, steps (F) (G), and (H) can be omitted.

### (F) Removing the inner pillar structure 4 - Fig. 4c

After patterning the dielectric material 3, and optionally other layers applied during step (C) the inner pillar structure 4 is removed down to the bottom 24 of the ring structure 2a, leaving a pillar vacancy 2b, as illustrated in Fig. 4c. The inner pillar structure can be removed to a level lower than the bottom of the trenches, for example when landing in the ILD layer with for example W contacts. The inner pillar structure can also be etched to a level higher than the bottom of the ring structure. When contacting the via structure from the second surface S2, in the latter case extra thinning may be added after the via process to expose the via from the second surface S2. The latter case may not be applicable to IC wafers since that side is where the BEOL is but it can be used for e.g. MEMS capping application where there is no BEOL. This removal of the inner pillar may be performed by etching. It can be performed by wet or dry etching or a combination of both.

At least one layer (not illustrated) comprising a different material than the rest of the substrate 1 is part of the substrate, and has to be removed partially, for example at the bottom of the inner pillar structure 4, for example to realize electrical contact with underlying devices, e.g. a PMD layer. Removing the at least one layer comprising different material can mean e.g., etching it away when removing the inner pillar structure 4. This may occur in one single process, e.g., one single etch step together with the other materials present in the pillar structure 4, or may be performed in different subsequent steps (etching sub-processes), depending on the materials present in the inner pillar structure 4. According to the invention, each step is adapted for selectively removing a substrate pillar sub-layer or subsequent sub-layers (for example by changing the etch chemistry in case of dry and/or wet etching), but always with a large selectivity with respect to the dielectric material 3 surrounding the substrate pillar structure 4 as this material has to stay (partially) in the hole. A typical example of such a layer is an inter level dielectric (ILD) layer, which is a layer present in a back-end-of-line (BEOL) interconnect structure; having a function of electrically isolating the metal interconnects in the BEOL from for example the front-end-of-line (FEOL). Typical ILD layers or ILD materials are an oxide, e.g. silicon oxide, Tetraethooxysilane (TEOS) Oxide, low-k dielectrics, polymers as BCB or polyimide (epoxy based polymers can be added).

The removal of the pillar structure 4 may be performed by etching, e.g. by dry etching. In particular embodiments Deep Reactive Ion Etching - Inductive Coupled Plasma (DRIE-ICP) may be used. In alternative embodiments, it can be first a wet etch and afterwards a dry etch. It can be first a wet etch of a semiconductor part, e.g. silicon part, of the pillar structure 4, followed by a dry etch of an ILD layer of the pillar. In yet alternative embodiments, it can be first a dry etch and afterwards a wet etch. It can be first a dry etch of a semiconductor part, e.g. silicon part, of the pillar structure 4, followed by a wet etch of an ILD layer of the pillar structure 4.

### (G) Providing a barrier layer.

Optionally, in certain embodiments of the present invention, a barrier layer (not illustrated) may be applied after having removed the inner pillar structure 4, rather than applying it between generating the ring structure 2a and filling the ring structure 2a with dielectric material 3. The details given with respect to the barrier layer provided during step (C) also hold for a barrier layer provided during this optional step (G).

### (H) Filling vacancy with conductive material - Fig. 4d

The vacancy 2b is at least partially filled with a conductive material 5, hereby forming an interconnect structure, the interconnect structure forming an electrical path from the bottom surface up until the first main surface.

Filling pillar vacancy 2b is preferably performed by first depositing a seed layer and then performing electroplating of the conductive material 5. The seed layer may cover the whole surface of the wafer, i.e. the top surface of the substrate 1 and the side walls and bottom wall of the vacancy 2b. The seed layer may be applied for instance by Chemical Vapor Deposition (CVD), by Physical Vapor Deposition (PVD), Electro Chemical Deposition (ECD), sputtering techniques, MOCVD, as well as by any other method known in the art.

Alternatively a metal paste, e.g. Cu paste, can be applied.

The conductive material 5 may be a metal. In particular embodiments, the conductive material may be copper (Cu), aluminum (Al), tungsten (W) or any other metals used in the field. The conductive material can also be an alloy, an implanted semiconductor, conductive silicon, conducting polymers. Also combinations of above mentioned materials can be used. The step of depositing a conductive material possibly creates an interconnect with an external contact. This step can comprise various sub-steps.

Extra layers underlying the conductive material or intermediate layers can be used. This can be for example improve the filling of the holes, adhesion of the conductive material, reduce the stress, prevent interdiffusion of materials

In particular embodiments of the present invention, the removed inner pillar structure 4 is completely filled with conductive material, e.g. metal, so as to form a conductive pillar, e.g. metal pillar 5.

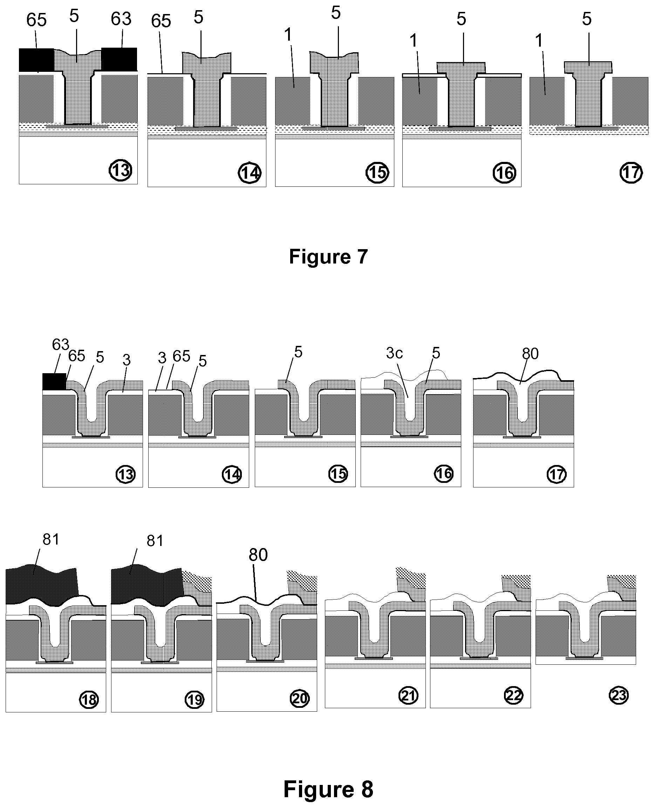

In alternative embodiments the interconnect structure is a layer of conductive material covering the bottom surface and side surfaces of the removed inner pillar structure 4, hereby leaving or forming an inner conductor hole. This can be produced by conformal plating of such layer. This is illustrated in Fig. 8 and Fig. 9. In preferred embodiments the inner conductor hole is filled with a dielectric material, see Fig. 8.

In particular embodiments, the dielectric material, conductive material for the interconnect structure, and the width of the ring structure are predetermined such that the ring structure is completely filled by the conductive material 5.

### (I) Thinning substrate

A method according to embodiments of the present invention may further comprise thinning the substrate 1 from the second main surface S2 until the created conductive structure 5 is reached. This embodiment results in an interconnect extending from the first main surface S1 to the second main surface S2 of the substrate 1. The interconnection is also called a via or through-hole or through silicon via (TSV) in silicon three-dimensional integration.

In embodiments of the present invention, the thinning can be performed by for instance mechanical operations such as grinding or other state of the art techniques. According to alternative embodiments of the present invention, the thinning may comprise chemically thinning, e.g. by dry etching or plasma etching the substrate 1 from the second main surface S2, the thinning being halted when the interconnect structure 5 is reached.

Also, according to yet other embodiments, the chemical thinning, e.g. plasma etching, may not stop at the level where the conductive structure 5_is reached, but may continue above that level (thus slightly over etching the substrate 1, e.g. silicon substrate). The interconnect structure (the conducting material 5 or the combined conductive material 5 and dielectric 3) will then stick out of the etched-back surface, which is advantageous for the addition of a solder volume such as a solder ball or bump. A solder volume as for instance a solder ball or solder bump can further be applied to the conductive structure on the second surface.

Some advantages of embodiments of the present invention include one or more of the following:
- since the dielectric material 3 is applied in liquid phase and is such that a planar surface is achieved, a patterning process performed by lithography can be applied on such planar surface very accurately, which would be less the case for non-planar surfaces; process flow, litho and etch on topography wafers (e.g. opening a dielectric at the bottom of the trench or ring) is source of numerous issues.
- The embodiments of the present invention provide a cheaper and more performing dielectric process. In prior art process flows, dielectrics are deposited by CVD, which is relatively expensive. Spray coating is typically more expensive than spin coating but still cheaper than CVD. Since CVD leads to large topography, a negative impact on yield results.

In embodiments of the present invention, a method is disclosed wherein the substrate 1 comprises at least one internal metal surface and wherein the ring structure 2a is etched up until the metal surface, the internal metal surface hereby serving as an etch stop surface or layer.

The internal metal surface may be the first metal layer of the BEOL in typical embodiments.

Particular embodiments of the present invention may be applied on carrier, i.e., while the second main surface S2 of the substrate 1 is further bonded to a temporary carrier 50 (see Fig. 5, part 1) by a bonding agent 51. This bonding agent 51 can preferably be temporary. This is preferably done before an optional thinning of the substrate 1 (see Fig. 5, part 2), and before providing, e.g., etching ring structures 2a (see Fig. 5, part 3). In those embodiments the bonding agent 51 is preferably a low temperature bonding agent, which can withstand temperatures up to 400°C or up to 250°C or up to 170°C or up to 150°C or up to 130°C. The embodiments of the present invention in which a temporary bonding agent 51 and thus a carrier 50, being a second temporary substrate which forms together with the substrate 1 a composite substrate, is present, all processes are preferably performed at temperatures which the temporary bonding agent 51 can withstand, e.g. below 250°C, or below 170°C, or below 150°C or below 130°C.

Another aspect of the invention provides a device comprising electrical interconnects fabricated by any of the methods as described above. Another aspect of the invention provides an electrical interconnect, produced by any of the above-described methods.

Hereinafter, particular embodiments of method flows according to embodiments of the present invention are described. Details of the flows, if not given here, can be according to any of the method embodiments described above.

A first embodiment of a process flow is illustrated in Fig. 5.

The target device wafer, substrate 1, is being glued or bonded onto a carrier wafer 50, as illustrated in Fig. 5, part 1. This gluing or bonding may be performed by means of a temporary gluing or bonding material 51. In the embodiment illustrated, the device wafer 1 comprises a metal 52 which is part of the front-end (e.g. W plugs), back-end (e.g. Cu or Al) or packaging layer (e.g. Cu or Al), and an ILD layer 53 which may be part of the back-end of line stack. The ILD layer can be the first ILD of the interconnects or a layer present at the passivation level.

The device wafer 1 is thinned, as illustrated in Fig. 5, part 2. This may be performed by grinding the back side of the device wafer 1 so that the final device wafer thickness is lower than the original device wafer thickness. In particular embodiments, the device wafer thickness may be about 50 µm.

While still being on the carrier wafer 50, a photoresist process is applied on the ground surface S1 in order to define an annular geometry. A deep reactive ion etch of the annular geometry is being performed, as illustrated in Fig. 5, part 3, thus forming a donut or ring structure 2a. The etching stops for example onto the ILD layer of the device wafer 1 (front-side of the device wafer). This ILD layer is a part of the back-end of line stack, it can be the first ILD of the interconnects or a layer present at the passivation level.

A dielectric material 3, e.g. a polymer such as for example BCB, is applied by means of spray or spin coating onto the wafer 1, as illustrated in Fig. 5, part 4. The annular structure 2a gets filled-up and the surface of the wafer 1 is being passivated by this dielectric material 3, e.g. polymer. In embodiments of the present invention a double coating 3a, 3b as described above could be applied.

A second lithography step (with for example resist of a photosensitive second dielectric layer) defines an opening in the dielectric material 3, e.g. a polymer opening, on top of the inner remaining substrate, e.g. Si, pillar 4. The dielectric material, e.g. polymer, may for example be dry etched so that the substrate surface, e.g. Si surface, is exposed where the inner pillar structure 4 is present. An etch process, such as for example Deep Reactive Ion etching or a wet process such as concentrated TMAH solution being heated up to about between 60°C and 80°C, may be used to remove, e.g. etch completely the inner pillar structure 4. The removal process, e.g. etch process may stop onto the ILD layer previously described. Due to the nature of the processes the mechanical integrity of the dielectric material 3, e.g. polymer, is preserved.

A second removal step, e.g. etch step, is then used to selectively remove, e.g. etch, the ILD layer to the underlying metal layer at the bottom of the via. The removal, e.g. etch, of the ILD layers stop onto the metal 52, as illustrated in Fig. 5, part 5.

If present, the photo resist layer (not illustrated) located on top of the dielectric material 3, e.g. polymer, is removed and, while still mounted on the carrier wafer 50, the device wafer 1 with carrier wafer 50 undergo a Ti/Cu seed layer deposition (not illustrated). This seed layer deposition may be done by PVD. In alternative embodiments it can also be done by Ionized PVD or MOCVD. Optionally the seed can be repaired by an electroless process.

A third lithographic step defines the resist (not illustrated) that is going to be used as a mold for providing conductive material 5, on the ground surface, e.g. a mold for metal plating, such as e.g. Cu plating. The wafer may be electroplated by means of electro-chemical deposition process, and the interconnects can be redistributed in this way. As a result the via, i.e. the hole previously provided, is filled by conductive material such as metal, e.g. Cu, as illustrated in Fig. 5, part 6, allowing later on an electrical connection between the back-side surface of the ground wafer 1 and the metal present in the front-side of another wafer.

Optionally the surface of the applied conductive material, e.g. metal such as Cu, is being planarised, as illustrated in Fig. 5, part 7, in order to allow for further assembly where planarity is required (e.g. AKA micro-bumping). The planarization may be a mechanical planarization, such as for example grinding or fly-cutting.

Thereafter, the resist is removed (not illustrated) and the seed layer is removed, e.g. etched (not illustrated). Optionally the back-side of the ground wafer is being further passivated by for instance a another layer of polymer (not illustrated).

The device wafer 1 and the carrier wafer 50 are released, for example by means of heat and/or shear movement, as illustrated in Fig. 5, part 5.

During the via formation the temperature of the device wafer 1 with carrier wafer 50 preferably never exceeds the temperature which the temporary bonding layer can stand without curing, e.g. it never exceeds about 130°C.

After debonding the wafer 1 from the carrier 50, devices as obtained can be stacked, as illustrated in Fig. 5, part 9.

A second, third and fourth embodiment of a process flow are illustrated in Fig. 6 in combination with Fig. 7, Fig. 8 and Fig. 9, respectively.

Fig. 6, part 1, illustrates provision of a device wafer 1, for example a silicon device wafer. The device wafer 1 comprises a metal 52 which is part of the front-end (e.g. W plugs), back-end (e.g. Cu or Al) or packaging layer (e.g. Cu or Al), and an ILD layer 53 which may be part of the back-end of line stack. The ILD layer can be the first ILD of the interconnects or a layer present at the passivation level.

The device wafer 1, is glued or bonded onto a carrier wafer 50, as illustrated in Fig. 6, part 2. This gluing or bonding may be performed by means of a temporary gluing or bonding material 51.

The device wafer 1 is thinned, as illustrated in Fig. 6, part 3. This may be performed by grinding the back side of the device wafer 1 so that the final device wafer thickness is lower than the original device wafer thickness. In particular embodiments, the device wafer thickness may be about 50 µm.

While still being on the carrier wafer 50, a photoresist process is applied on the ground surface S1 in order to define an annular geometry, as illustrated in Fig. 6, part 4. This implies application of a photosensitive layer, e.g. photoresist 60 and patterning of this layer 60 so as to define the annular geometry.

The patterned photosensitive layer 60 is then used as a mask for etching the substrate 1 so as to provide a ring structure 2a. A deep reactive ion etch of the annular geometry may be performed, as illustrated in Fig. 6, part 5, thus forming a donut or ring structure 2a. The etching stops onto the ILD layer 53 of the device wafer 1 (front-side of the device wafer). This ILD layer is a part of the back-end of line stack, it can be the first ILD of the interconnects or a layer present at the passivation level.

Thereafter, the photosensitive layer 60 is stripped by any suitable process known by a person skilled in the art, as illustrated in Fig. 6, part 6.

A dielectric material 3, e.g. a polymer such as for example BCB, is applied by means of spray or spin coating onto the wafer 1, as illustrated in Fig. 6, part 7. The annular structure 2a gets filled-up and the surface of the wafer 1 is being passivated by this dielectric material 3, e.g. polymer. In embodiments of the present invention a double coating 3a, 3b as described above could be applied.

A second lithography step defines an opening in the dielectric material 3, e.g. a polymer opening, on top of the inner remaining substrate pillar 4. Therefore, a photosensitive layer 61, e.g. photresist, is applied and patterned, as illustrated in Fig. 6, part 8.

The dielectric material 3, e.g. polymer, may for example be dry etched so that the substrate surface, e.g. Si surface, is exposed where the inner pillar structure 4 is present (not illustrated).

An etch process, such as for example a plasma etch, or a Deep Reactive Ion etching or a wet process such as concentrated TMAH solution being heated up to about between 60°C and 80°C, may be used to remove, e.g. etch completely the inner pillar structure 4. The removal process, e.g. etch process stops on the ILD layer previously described. Due to the nature of the processes the mechanical integrity of the dielectric material 3, e.g. polymer, is preserved. A further removal step, e.g. etch step, is then used to selectively remove, e.g. etch, the ILD layer 53 to the metal 52 at the bottom of the via. The removal, e.g. etch, of the ILD layers stop onto the metal 52, as illustrated in Fig. 6, part 9.

The photo resist 61 located on top of the dielectric material 3, e.g. polymer, is removed, as illustrated in Fig. 6, part 10.

Thereafter, while still mounted on the carrier wafer 50, the device wafer 1 and carrier wafer 50 combination undergo a seed layer 65 deposition, e.g. a Ti/Cu seed layer deposition (Fig. 6, part 11). This seed layer deposition may be done by PVD. In alternative embodiments it can also be done by Ionized PVD or MOCVD. Optionally the seed can be repaired by an electroless process.

A third lithographic step defines the resist 63 that is going to be used as a mold for providing conductive material 5, e.g. a mold for metal plating, such as e.g. Cu plating.

The above description is common for the second, third and fourth process flows.

The second process flow is further illustrated in Fig. 7.

The wafer is electroplated by means of electro-chemical deposition process, as illustrated in Fig. 7, part 13. As a result the via, i.e. the hole previously provided, is filled by conductive material 5 such as metal, e.g. Cu, allowing later on an electrical connection between the back-side surface of the ground wafer 1 and the metal present in the front-side of another wafer.

Thereafter, the resist 63 is removed (Fig. 7, part 14) and the seed layer 65 is removed, e.g. etched (Fig. 7, part 15).

Optionally the surface of the applied conductive material 5, e.g. metal such as Cu, is being planarised, as illustrated in Fig. 7, part 16, in order to allow for further assembly where planarity is required (e.g. AKA micro-bumping). The planarization may be a mechanical planarization, such as for example grinding or fly-cutting.

The device wafer 1 is debonded from the carrier wafer 50, for example by means of heat and/or shear movement, as illustrated in Fig. 7, part 17.

The third process flow is further illustrated in Fig. 8, starting from the situation in part 12 of Fig. 6.

A conformal electroplating of conductive material 5, e.g. metal such as Cu, is performed, as illustrated in Fig. 8, part 13. The resist 63 is stripped (Fig. 8, part 14), and the seed layer 65, previously present under the resist 63, is removed, e.g. etched away (Fig. 8, part 15).

A third dielectric layer 3c, e.g. polymer, is applied and patterned (Fig. 8, part 16). This polymer is used to passivate the Cu lines and the patterning is required for the following bump (solder or TLP...) formation process on top of the Cu pad.

A further seed layer 80 is deposited, e.g. Ti/Cu seed layer (Fig. 8, part 17). This seed layer deposition may be done by PVD. In alternative embodiments it can also be done by Ionized PVD or MOCVD. Optionally the seed can be repaired by an electroless process. Seed repair improves filling of the via for example when using Cu plating inside the via.

A further resist 81 is applied and patterned (Fig. 8, part 18) to plate the bump material (Fig. 8, part 19) for example Cu plating followed by Tin (Sn) plating. The resist that is put there for bump plating is stripped (Fig. 8, part 20) and the Ti/Cu seed 80 is etched (Fig. 8, part 21) (typically wet). As an option, the Sb surface can be planarized (Fig. 8, part 22), for example by fly cutting, for increased yield during flipchip bonding. Finally, the temporary carrier is removed either before or after 3D stacking (Fig. 8, part 23).

The fourth process flow is further illustrated in Fig. 9, starting from the situation in part 12 of Fig. 6.

A conformal electroplating of conductive material 5, e.g. metal such as Cu, is performed, as illustrated in Fig. 9, part 13. The resist 63 is stripped (Fig. 9, part 14), and the seed layer 65, previously present under the resist 63, is removed, e.g. etched away (Fig. 8, part 16).

Optionally the surface of the applied conductive material 5, e.g. metal such as Cu, is being planarised, as illustrated in Fig. 9, part 16, in order to allow for further assembly where planarity is required (e.g. AKA micro-bumping). The planarization may be a mechanical planarization, such as for example grinding or fly-cutting.

The device wafer 1 is debonded from the carrier wafer 50, for example by means of heat and/or shear movement, as illustrated in Fig. 9, part 17.

In the embodiments of the third and fourth process flow, the interconnect structure is a layer of conductive material 5 covering the bottom surface and side surfaces of the removed inner pillar structure 4, hereby leaving or forming an inner conductor hole. In the embodiment illustrated in Fig. 8, the inner conductor hole is filled with a dielectric material.

### Selectivity tests of silicon removal with respect to the BCB dielectric layer.

The experimental results given below are for BCB, but similar tests were done for RH8023-10, showing similar results.

By using a DRIE process, a silicon pillar 4 was etched at a rate of about 3 µm/min, while the BCB 3 was removed at a rate of 2 µm/30 min (or 0.067 µm/min) on a horizontal surface. Given that the etching of a substantially horizontal surface is typically quicker than the etching of an essentially vertical surface (side surface of the pillar vacancy 2b), the selectivity of the DRIE removal step over the BCB is larger than 1:45.

By using a wet etch, using 20%TMAH at 80° C, a perfect removal of the silicon pillar 4 was achieved, while the BCB 3 was unaffected. This means that the selectivity is infinite.

BCB is thus compatible with both the DRIE etch and even more with the wet TMAH etch.

### Some experimental results

Silicon wafers 1 were provided with ring structures 2a by dry etching. The first main surface of the substrate 1 was pre-treated with an adhesion promoter, e.g. AP3000 from Dow Chemicals, at 70°C, followed by the application of a BCB layer 3 via spin coating at room temperature (about 20°C). BCB 3022-46 was used, spread for 20 s at 500 rpm rotation speed, followed by 10 s at 2000 rpm rotation speed.

The 5 µm large trench was half -filled without voids (before cure) (cfr Fig. 10). A second BCB coat has then successfully been applied to fill the via completely for the 5 µm wide trenches.

Successful experiments have been done with 3D SIC wafers, which were coated by an oxide. The trenches were partialy filled with BCB (see

Fig.10) and fully filled with BCB 3. The filling rate was dependent on trench density.

An oxide layer present at the interface between the BCB 3 and the silicon pillar 4 provides appropriate wetting properties to allow for a more easily filling (or complete filling) of the trenches. It could provide also the function of etch stop layer, and possibly also as a diffusion barrier layer (avoiding metal atoms, e.g. copper atoms, to diffuse into and through the BCB into the neighboring substrate).

Experiments were performed wherein the substrate 1 was heated while being coated by BCB, at temperatures within the 50-70°C range. The trenches were almost filled and the filling efficiency was improved.

Experiments with double coat to demonstrate full annular fill were performed. Applying two or more steps, eg a multitude of steps applied subsequently, improves the filling process of the trenches.

Polymers like BCB can be deposited at relatively low temperatures, when compared to for instance CVD Si oxide deposition. A typical prior art CVD Silicon oxide deposition step in order to create isolated holes, is also often limited by the characteristic of bad step coverage properties. Silicon oxide deposition typically also produces layers with about uniform thickness, which limits design freedom. Silicon oxide can easily build up stress and is not flexible.

BCB is patternable, since it is for instance anisotropically dry or plasma-etchable. BCB is easy to process and spin and spray coatable. It has good planarization properties. BCB is flexible and low stress formation appears. BCB provides a large design freedom. Water absorption is low. Adhesion properties to substrate and conductor are present. Other properties of BCB can be found in Burdeaux et al., "Benzocyclobutene (BCB) Dielectrics for the Fabrication of High Density, Thin Film Multichip Modules.", journal of Electronic materials, Vol. 19, No. 12, 1990.

### Experiment

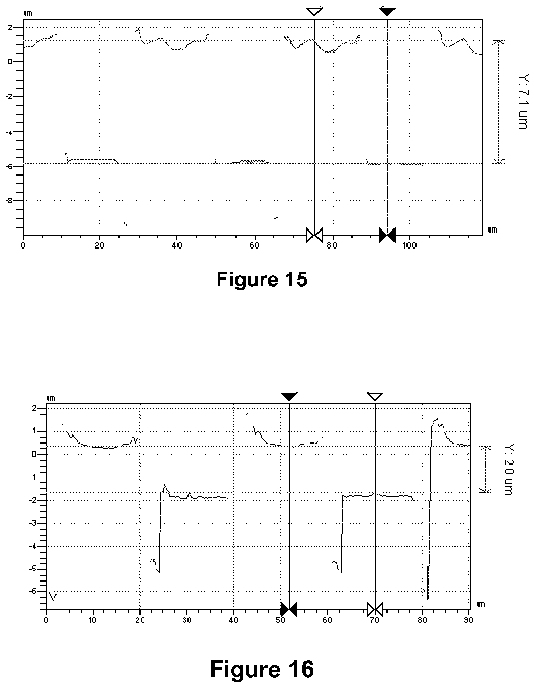

Fig. 15 shows topography measurement on the print after etching the second dielectric layer (cfr. Fig. 14(c)) produced by the 3 step procedure represented in Figure 14. Twice the same dielectric layer was used, with the same viscosity i.e. RH8023-10 spun at 60°C. The thickness of the polymer is ∼7µm. This polymer is photopatternable and should be soft baked at ∼100°C, exposed, and developed after spinning and then finally cured at ∼190°C. It was found that softbake reduced the filling performance and increased the surface rougnhess. When spinning the material and moving to the final curing at ∼190°C directly (no softbake, exposure or development), the filling of the trenches improved. Therefore, after spinning, the first dielectric layer received direct cure. The second dielectric layer received standard litho processing of the polymer, i.e. softbake at ∼100°C, exposure, development and finally cure at ∼190°C. The thickness of this layer is about 7 µm.

Fig. 15 shows a topography measurement after patterning the second dielectric layer on top of the center Si block. It shows nice definition of the mask pattern on the second dielectric layer. In this case, both first (for filling) and second (for surface coverage after recess and patterning) dielectric layers are the same viscosity version of the same material, which is a thick version because filling is more efficient. This graph shows a good definition of the mask pattern using double coating of dielectric layers with a recess etch in between and using the photo patternable properties of the second dielectric layer, while first layer is used just to fill the ring trench.

Fig. 16 shows the topography measurement on the print produced by the above-mentioned 3 step procedure represented in Fig. 14 and using two different viscosity versions of the same dielectric layer where the filling is done by the less viscous version. The diluted version of the same material is used for the second layer. The thickness of the second layer is 2 µm. Fig. 16 shows a topography measurement after patterning the dielectric layer on top of the center Si block. It shows nice definition of the mask pattern on the second dielectric layer. In this case the two dielectric layers have a different viscosity, i.e. the second dielectric on top has a higher viscosity than the first dielectric. Hence, the second dielectric layer applied after recess is a thinner version of the first one which is used for filling. The second dielectric in this case is thinner than in Fig. 15. This graph also shows a good definition of the mask pattern using double coating of dielectric layers with a recess etch in between and using the photo patternable properties of the second (thinner) dielectric layer, while first layer is used just to fill the ring trench.

The thermo-mechanical properties of polymers and silicones are such that "flexible" and less fragile structures, more specifically interconnect structures can be created. One embodiment of the invention allows smaller pitch and thus higher density interconnects. The method according to one embodiment of the present invention provides quicker, easier and cheaper processing.

The foregoing description details certain embodiments of the invention. It will be appreciated, however, that no matter how detailed the foregoing appears in text, the invention may be practiced in many ways.

It is to be understood that although preferred embodiments, specific constructions and configurations, as well as materials, have been discussed herein for devices according to the present invention, various changes or modifications in form and detail may be made without departing from the scope of this invention as defined by the appended claims.

While the above detailed description has shown, described, and pointed out novel features of the invention as applied to various embodiments, it will be understood that various omissions, substitutions, and changes in the form and details of the device or process illustrated may be made by those skilled in the technology without departing from the invention as defined by the appended claims.

## Claims

1. A method for the fabrication of at least one electrical interconnect in a substrate, comprising:
- Providing a substrate (1) being a semiconductor wafer or die made of a substrate material and having a first main surface (S1) and comprising a back-end-of-line (BEOL) and a front-end-of-line (FEOL), wherein the first main surface (S1) is the backside of the wafer or die, i.e. the side which is remote from the BEOL;
- Producing at least one ring structure (2a) in a substrate from the first main surface, the at least one ring structure surrounding an inner pillar structure (4) of substrate material with a top, and having a bottom surface;
- Filling the at least one ring structure (2a) with a first dielectric material (3) with spin-on or spray-on or CVD in the ring structure (2a) and on the first main surface (S1)
- Removing the first dielectric material (3) to a level equal or higher than the first main surface (S1)
- Applying a second dielectric material on the first main surface (S1);
- Removing the second and first dielectric material when present from the top of the inner pillar structure (4) to open up the pillar structure;
- Removing the inner pillar structure (4) down to the bottom surface of the ring structure (2a), leaving a pillar vacancy (2b) selectively to the dielectric material (3) surrounding the pillar structure (4) wherein the removal of the pillar structure stops on an interlayer dielectric (ILD) layer of the substrate that is subsequently selectively removed in a second removal step to an underlying metal layer and stops on the underlying metal layer;
- Providing a conductive inner pillar structure in the at least one ring structure, by at least partially filling the pillar vacancy (2b) with a conductive material, thereby forming at least one interconnect structure, the at least one interconnect structure forming an electrical path from the bottom surface (24) up until the first main surface (S1),

2. The method as claimed in Claim 1, wherein the first dielectric material (3) is a polymer, an oxide or a nitride.

3. The method as claimed in Claim 1 or 2, wherein the first dielectric material (3) is applied in liquid phase.

4. The method according to any of claims 1 to 3, wherein the second dielectric material is photo-patternable.

5. The method as claimed in any of the claims 1 to 4, further comprising thinning the substrate (1) from a second main surface (S2) opposite the first main surface (S1) until the interconnect structure is reached.

6. The method as claimed in claim 1, further comprising providing a solder ball or bump to the interconnect structure.

7. The method as claimed in claim 1, wherein the removal of the pillar structure occurs by dry etching.

8. The method as claimed in claim 1, wherein the removal of the pillar structure comprises a dry etch and a wet etch.

## Patentansprüche

1. Verfahren für die Herstellung zumindest einer elektrischen Verbindung in einem Substrat, umfassend:
- Bereitstellen eines Substrats (1), bei dem es sich um eine Halbleiterscheibe oder einen Halbleiterchip aus einem Substratmaterial handelt, und das eine erste Hauptfläche (S1) aufweist und ein Back-End-of-Line (BEOL) und ein Front-End-of-Line (FEOL) umfasst, wobei die erste Hauptfläche (S1) die Rückseite der Scheibe oder des Chips ist, d. h. die Seite, die von dem BEOL entfernt ist;
- Erzeugen zumindest einer Ringstruktur (2a) in einem Substrat aus der ersten Hauptfläche, wobei die zumindest eine Ringstruktur eine innere Säulenstruktur (4) von Substratmaterial mit einem oberen Ende umgibt und eine Unterseite aufweist;
- Füllen der zumindest einen Ringstruktur (2a) mit einem ersten dielektrischen Material (3) mittels Aufschleudern oder Aufsprühen oder CVD in der Ringstruktur (2a) und auf der ersten Hauptfläche (S1);
- Entfernen des ersten dielektrischen Materials (3) auf ein Niveau, das gleich wie oder höher als die erste Hauptfläche (S1) ist;
- Aufbringen eines zweiten dielektrischen Materials auf die erste Hauptfläche (S1);
- Entfernen des zweiten und des ersten dielektrischen Materials, wenn vorhanden, von dem oberen Ende der inneren Säulenstruktur (4), um die Säulenstruktur zu öffnen;
- Entfernen der inneren Säulenstruktur (4) bis hinunter auf die Unterseite der Ringstruktur (2a), eine Säulenleerstelle (2b) selektiv bis zu dem die Säulenstruktur (4) umgebenden dielektrischen Material (3) zurücklassend, wobei die Entfernung der Säulenstruktur auf einer Interschicht-Dielektrikum(ILD)-Schicht des Substrats stoppt, die nachfolgend in einem zweiten Entfernungsschritt bis zu einer zugrunde liegenden Metallschicht selektiv entfernt wird und auf der zugrunde liegenden Metallschicht stoppt;
- Bereitstellen einer leitfähigen inneren Säulenstruktur in der zumindest einen Ringstruktur durch zumindest teilweises Füllen der Säulenleerstelle (2b) mit einem leitfähigen Material, wodurch zumindest eine Verbindungsstruktur gebildet wird, wobei die zumindest eine Verbindungsstruktur einen elektrischen Pfad von der Unterseite (24) hinauf bis zu der ersten Hauptfläche (S1) bildet.

2. Verfahren nach Anspruch 1, wobei das erste dielektrische Material (3) ein Polymer, ein Oxid oder ein Nitrid ist.

3. Verfahren nach Anspruch 1 oder 2, wobei das erste dielektrische Material (3) in der flüssigen Phase aufgebracht wird.

4. Verfahren nach einem der Ansprüche 1 bis 3, wobei das zweite dielektrische Material fotostrukturierbar ist.

5. Verfahren nach einem der Ansprüche 1 bis 4, das weiter ein Ausdünnen des Substrats (1) von einer der ersten Hauptfläche (S1) gegenüberliegenden zweiten Hauptfläche (S2), bis die Verbindungsstruktur erreicht wird, umfasst.

6. Verfahren nach Anspruch 1, das weiter ein Bereitstellen einer Lötkugel oder eines Lötballens an die Verbindungsstruktur umfasst.

7. Verfahren nach Anspruch 1, wobei die Entfernung der Säulenstruktur durch Trockenätzen erfolgt.

8. Verfahren nach Anspruch 1, wobei die Entfernung der Säulenstruktur ein Trockenätzen und ein Nassätzen umfasst.

## Revendications

1. Procédé pour la fabrication d'au moins une interconnexion électrique dans un substrat, comprenant :
- la fourniture d'un substrat (1) qui est une tranche ou un dé à semi-conducteur réalisé en un matériau de substrat et ayant une première surface principale (S1) et comprenant une unité de fabrication finale (BEOL) et une unité de fabrication initiale (FEOL), dans lequel la première surface principale (S1) est le côté arrière de la tranche ou du dé, c'est-à-dire le côté qui est éloigné de la BEOL ;
- la production d'au moins une structure d'anneau (2a) dans un substrat à partir de la première surface principale, l'au moins une structure d'anneau entourant une structure de pilier interne (4) de matériau de substrat avec un dessus, et ayant une surface de dessous ;
- le remplissage de l'au moins une structure d'anneau (2a) avec un premier matériau diélectrique (3) avec rotation ou pulvérisation ou dépôt chimique en phase vapeur dans la structure d'anneau (2a) et sur la première surface principale (S1)
- l'élimination du premier matériau diélectrique (3) jusqu'à un niveau supérieur ou égal à la première surface principale (S1)
- l'application d'un second matériau diélectrique sur la première surface principale (S1) ;
- l'élimination des second et premier matériaux diélectriques lorsqu'ils sont présents du dessus de la structure de pilier interne (4) pour ouvrir la structure de pilier ;
- l'élimination de la structure de pilier interne (4) jusqu'à la surface de dessous de la structure d'anneau (2a), laissant sélectivement un espace en forme de pilier (2b) au matériau diélectrique (3) entourant la structure de pilier (4) dans lequel l'élimination de la structure de pilier s'arrête sur une couche diélectrique intercouche (ILD) du substrat qui est ensuite éliminée sélectivement à une seconde étape d'élimination jusqu'à une couche de métal sous-jacente et s'arrête sur la couche de métal sous-jacente ;
- la fourniture d'une structure de pilier interne conductrice dans l'au moins une structure d'anneau, en remplissant au moins partiellement l'espace en forme de pilier (2b) avec un matériau conducteur, formant ainsi au moins une structure d'interconnexion, l'au moins une structure d'interconnexion formant un chemin électrique depuis la surface de dessous (24) jusqu'à la première surface principale (S1).

2. Procédé selon la revendication 1, dans lequel le premier matériau diélectrique (3) est un polymère, un oxyde ou un nitrure.

3. Procédé selon la revendication 1 ou 2, dans lequel le premier matériau diélectrique (3) est appliqué en phase liquide.

4. Procédé selon l'une quelconque des revendications 1 à 3, dans lequel le second matériau diélectrique est photostructurable.

5. Procédé selon l'une quelconque des revendications 1 à 4, comprenant en outre l'amincissement du substrat (1) depuis une seconde surface principale (S2) opposée à la première surface principale (S1) jusqu'à ce que la structure d'interconnexion soit atteinte.

6. Procédé selon la revendication 1, comprenant en outre la fourniture d'une bille ou perle de soudure à la structure d'interconnexion.

7. Procédé selon la revendication 1, dans lequel l'élimination de la structure de pilier se produit par gravure sèche.

8. Procédé selon la revendication 1, dans lequel l'élimination de la structure de pilier comprend une gravure sèche et une gravure humide.
